# DEMANDE DE BREVET EUROPEEN

(11) **EP 0 526 280 A1**
(43) Date de publication de la demande: **03.02.1993**
(21) Numéro de dépôt: 92401896.3
(22) Date de dépôt: 02.07.1992
(51) Int. Cl.: B41F 27/00, G03F 9/00

(54) **Procédé et dispositif de positionnement d'un cliché sur un cylindre d'impression**

(30) Priorité: 03.07.1991 FR 9108329
(71) Demandeur: C.E.E.- COMPAGNIE EUROPEENNE DES EMBALLAGES ROBERT SCHISLER, F-79100 Thouars (FR)
(72) Inventeur: Fallone, Patrice, F-79100 Thouars (FR)
(74) Mandataire: Bruder, Michel

(57) **Abrégé**

La présente invention concerne un procédé et un dispositif de positionnement d'une série de clichés (10), sur des cylindres d'impression (19) dans lequel on réalise sur un film masque transparent (1), au moins deux zones masque (5), on insole le cliché (10) au travers du film masque transparent (1), on élimine les parties non insolées du cliché (10) de façon à obtenir sur le cliché (10), un élément repère en creux (18).

Suivant ce procédé et ce dispositif on met en contact avec chaque élément (18) repère un élément (38) de forme complémentaire, de façon à assurer le positionnement et le maintien de l'élément repère (18), on fixe, sur le cylindre d'impression (19), la partie de cliché (10) non maintenue par les éléments de forme complémentaire (18), on libère la partie de cliché (10) maintenue par ces derniers, on termine la fixation du cliché (10) sur le cylindre d'impression (19).

## Description

La présente invention concerne un procédé et un dispositif destinés à assurer le positionnement d'un cliché sur un cylindre d'impression.

On sait que certains dispositifs d'impression, par exemple de type trichrome ou quadrichrome, utilisent le passage successif, sur le support à imprimer, de clichés imprégnés de couleurs différentes, qui sont destinées à se superposer sur le support de façon à constituer un ensemble de formes et de couleurs déterminées. On comprend ainsi que le positionnement successif des clichés sur le support doit se faire de façon extrêmement rigoureuse, sous peine de détruire les formes et les couleurs prévues par le concepteur. C'est pourquoi les machines d'impression utilisant de telles techniques comportent des moyens de réglage destinés à compenser les éventuels décalages pouvant se manifester lors de la mise en place des clichés sur les cylindres d'impression.

Les machines d'impression comprennent ainsi des moyens permettant, d'une part, de déplacer les cylindres d'impression revêtus de leurs clichés respectifs suivant l'axe longitudinal de ceux-ci et, d'autre part, de modifier la position angulaire relative de chaque cylindre d'impression. Cependant, pour que de tels réglages de positionnement soient efficaces, il est impératif que chacun des clichés soit positionné angulairement de la même manière par rapport aux génératrices de son propre cylindre d'impression.

Suivant la technique antérieure, pour réaliser un tel positionnement, on forme sur chacun des clichés au moins deux repères, constitués la plupart du temps par des croix, qui sont disposées de façon identique par rapport au sujet à reproduire, et que l'on positionne de la même façon par rapport à une génératrice du cylindre d'impression.

Afin que ces repères soient disposés de façon rigoureusement identique sur chacun des clichés, c'est-à-dire en un même endroit par rapport au sujet à reproduire, ils sont réalisés sur le film transparent portant le dessin, à partir duquel on réalise les différents clichés. De cette façon, au cours des opérations successives par lesquelles on forme, au moyen du film transparent initial les différents clichés, les repères sont ainsi reproduits sur chacun de ceux-ci, dans des positions identiques par rapport au sujet. On fixe ensuite chacun des clichés sur son cylindre d'impression spécifique en le disposant de telle façon que les repères coïncident avec des repères du cylindre d'impression, qui sont identiques d'un cylindre à l'autre, et qui sont habituellement constitués d'un trait réalisé sur une génératrice de celui-ci. Un tel positionnement comporte des imprécisions qui proviennent, d'une part, de l'appréciation propre à l'opérateur quant au positionnement des repères sur la génératrice du cylindre d'impression, cette imprécision étant accrue, la plupart du temps, par l'épaisseur des repères et la largeur du cliché.

Pour améliorer la précision, on a proposé de faire appel à des caméras vidéo qui, grâce au grossissement des repères qu'elles procurent, permettent d'obtenir un positionnement quasi parfait des clichés sur les cylindres d'impression respectifs.

Ces derniers moyens présentent cependant l'inconvénient d'être très onéreux.

On a proposé également, dans le brevet GB-A-2215665 un dispositif positionneur de cliché qui utilise une structure en relief, ou en creux, formée sur le cliché, pour assurer le positionnement d'un outillage destiné à perforer, de part en part, le cliché ce qui permet d'obtenir ainsi sur ce dernier des éléments repères. Il est également proposé de réaliser des éléments repères, males et femelles, qui coopérent entre eux. Dans ce type de dispositif, ces éléments n'étant pas de formes respectivement complémentaires, le positionnement du cliché par rapport à son support n'est pas assuré de façon précise.

La présente invention a pour but de proposer un procédé et un dispositif permettant d'assurer un positionnement précis des clichés sur les cylindres d'impression respectifs d'une machine, qui soit à la fois facile à mettre en oeuvre et d'un prix de revient particulièrement intéressant.

La présente invention a ainsi pour objet un procédé de positionnement d'une série de clichés, par exemple en photopolymère, sur des cylindres d'impression dans lequel:
- on réalise sur un film masque transparent, conjointement au dessin d'un sujet à reproduire, au moins deux zones masque, disposées à distance l'une de l'autre,
- on insole le cliché au travers du film masque transparent,
- on élimine les parties non insolées du cliché par attaque chimique de celui-ci, de façon à obtenir sur le cliché, à l'endroit de chaque zone masque, un élément repère, caractérisé en ce que, de façon successive pour chacun des clichés :
- on réalise des zones masques constituées de deux zones opaques, sensiblement au milieu desquelles est formée une zone non masquée, de façon à constituer sur le cliché, après contretypage du film masque initial, une partie en relief au centre de laquelle se trouve une cuvette,
- on met, en contact avec chaque bord interne de chaque cuvette un élément de forme complémentaire de celle-ci, dont la position par rapport à l'axe longitudinal zz′ de chaque cylindre d'impression est respectivement la même, de façon à assurer le positionnement et le maintien de la cuvette par l'élément de forme complémentaire,
- on fixe, sur le cylindre d'impression, la partie de cliché non maintenue par les éléments de forme complémentaire,
- on libère la partie de cliché maintenue par ces derniers,
- on termine la fixation du cliché sur le cylindre d'impression.

Dans un mode de mise en oeuvre de l'invention, on peut, après le positionnement de chacun des clichés sur son cylindre respectif, supprimer la partie en relief de l'élément repère de façon à éviter son impression sur le support à imprimer.

Dans une variante intéressante de l'invention le fond de la cuvette est de forme sensiblement semi-sphérique, et l'élément de forme complémentaire est constitué d'une broche d'extrémité semi-sphérique.

Bien entendu, on peut, par exemple, conserver l'un de ces éléments repère, qui jouera alors le rôle de zone témoin de contrôle de couleur.

La présente invention a également pour objet un dispositif de positionnement de clichés sur des cylindres d'impression respectifs, caractérisé en ce qu'il comprend :
- des moyens de positionnement, aptes à disposer et à maintenir les différents cylindres d'impression, de façon que leur axe longitudinal zz′ soit disposé suivant une direction fixe déterminée,
- des moyens de maintien, constitués d'au moins deux éléments de forme complémentaire d'éléments repère, réalisés en creux sur chacun des différents clichés, aptes à coopérer avec ces derniers pour positionner et maintenir chacun des clichés suivant une même direction déterminée par rapport à l'axe zz′ du cylindre d'impression.

Dans un mode de mise en oeuvre particulièrement intéressant de l'invention, les éléments repères sont en forme de cuvette semi-sphérique et les moyens de maintien sont, en conséquence, également de forme semi-sphérique. La demanderesse a constaté que lorsque les moyens de maintien destinés à coopérer avec les cuvettes semi-sphériques du cliché avaient un diamètre identique à celui de ces dernières, le positionnement du cliché étant effectué de façon particulièrement précise, et facile.

Dans une variante de mise en oeuvre du dispositif suivant l'invention, les moyens de positionnement de l'axe zz′ d'un cylindre d'impression sont constitués de deux supports identiques, dont la partie supérieure est pourvue d'une échancrure en forme de V, ces deux supports étant disposés de telle façon que les intersections des parois des échancrures inférieures respectives soient alignées suivant l'axe zz′ suivant lequel on souhaite positionner l'axe du cylindre d'impression, et d'une platine support, parallèle à l'axe zz′ lorsque celui-ci est en place sur les supports, et qui supporte les moyens de maintien de forme complémentaire de l'élément repère.

La figure 1 est une vue partielle en plan, d'un film masque transparent sur lequel est dessiné un sujet à reproduire, et qui comporte des éléments repère suivant l'invention.

La figure 2 est une vue partielle en plan, à plus grande échelle, montrant un élément repère mis en oeuvre dans le procédé et le dispositif suivant l'invention.

La figure 3 est une vue en coupe verticale schématique illustrant l'étape d'insolation permettant d'obtenir un cliché d'impression.

La figure 5 est une vue partielle en coupe transversale suivant la ligne III-III de la figure 2, d'un élément repère suivant l'invention.

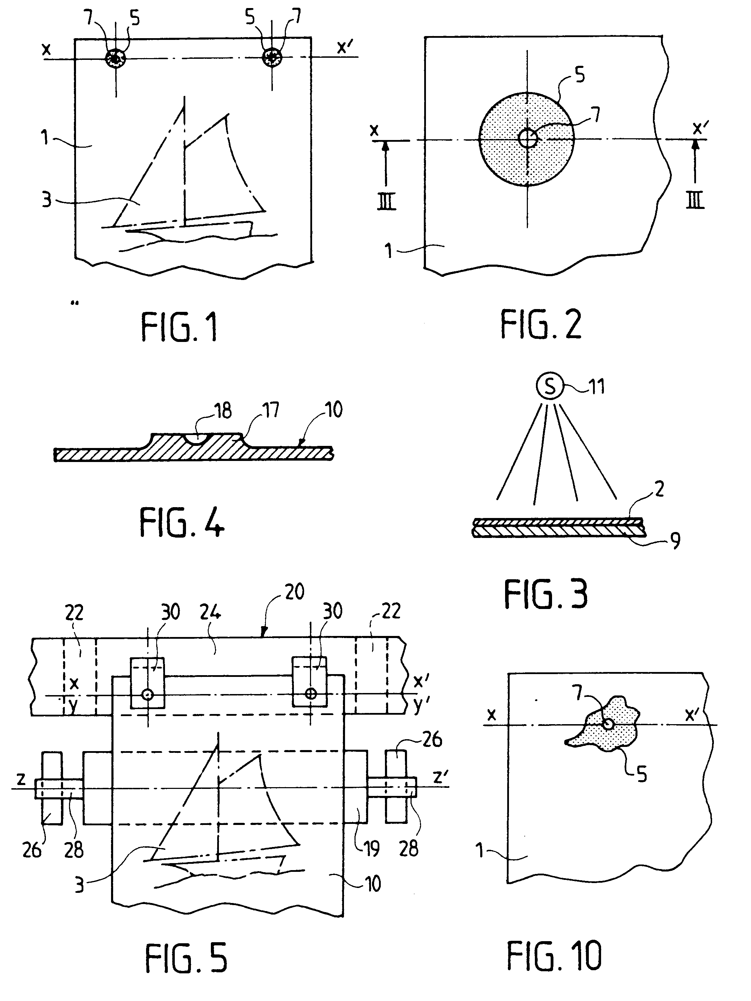

La figure 5 est une vue partielle en plan montrant le positionnement d'un cliché sur un cylindre d'impression.

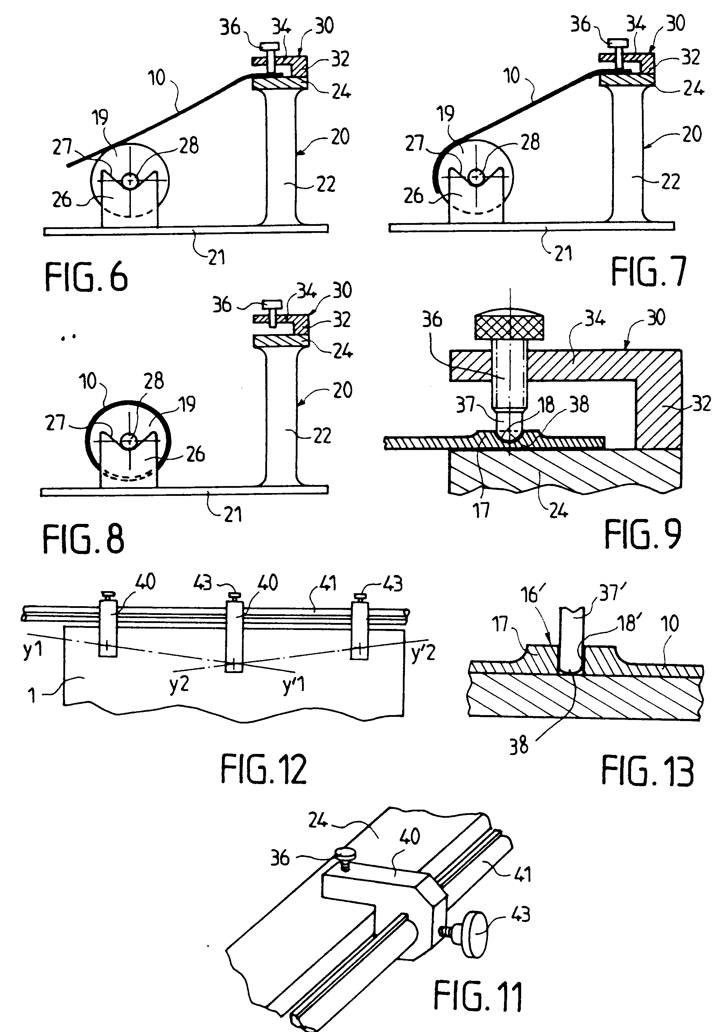

Les figures 6 à 8 sont des vues schématiques en élévation montrant les différentes phases de l'opération de mise en place, suivant l'invention, d'un cliché sur un cylindre d'impression.

La figure 9 est une vue partielle en coupe verticale, à plus grande échelle, montrant les moyens de positionnement et de maintien utilisés dans le procédé et le dispositif suivant l'invention.

La figure 10 est une vue partielle en plan, à plus grande échelle, d'un cliché d'impression comportant une variante de mise en oeuvre d'un élément repère suivant à l'invention.

La figure 11 est une vue partielle schématique en perspective d'une variante de mise en oeuvre de l'invention.

La figure 12 est une vue en plan schématique d'une autre forme de mise en oeuvre de l'invention.

La figure 13 est une vue partielle en coupe verticale, à plus grande échelle, d'un mode de mise en oeuvre de l'invention.

Sur les figures 1 et 2 on a représenté un film transparent 1, par exemple un film photographique, sur lequel on a représenté, en traits opaques, un sujet 3 que l'on souhaite reproduire sur un support, de façon à constituer un cliché initial.

Suivant l'invention, on a dessiné, à la partie supérieure du film 1, deux zones opaques 5 circulaires, au centre desquelles on a laissé non masquée une zone circulaire 7 de petit diamètre. Les centres de ces zones sont disposés suivant un axe xx′.

On utilise ensuite le film 1, ainsi réalisé, pour contretyper, de façon connue, une série de masques 2, à savoir un masque par couleur que l'on souhaite reproduire, et qui se présentent alors en négatif par rapport au cliché initial, c'est-à-dire que la zone 5 est transparente et le centre 7 de celle-ci est opaque. A partir de chacun de ces masques on réalise les différents clichés 10. Pour cela, comme représenté sur la figure 3, on applique, en contact étroit, le film masque 2 sur une feuille de photopolymère 9. (c'est-à-dire un film qui, après exposition sous une source lumineuse, pendant un temps déterminé, voit ses parties non insolées se décomposer lorsqu'on le soumet à l'action d'un produit chimique, ou révélateur, approprié). On éclaire donc le sandwich ainsi formé par une source de lumière ultraviolette 11, qui traverse les parties non masquées du film 1, et notamment la zone 5, pour éclairer la feuille de photopolymère 9. Cette dernière est ensuite immergée dans un bain de révélateur dissolvant les parties insolées par le rayonnement ultraviolet, et conservant les parties masquées qui se trouvent ainsi en relief par rapport aux parties attaquées du photopolymère 9. Ainsi, comme représenté sur la figure 4, les zones de la feuille de photopolymère 9 préservées de l'action des rayons ultraviolets par les zones opaques 7 du film masque 2, forment des parties en creux ou cuvettes 18, alors qu'à l'inverse les zones 5 de la feuille de photopolymère non préservées de l'action des rayons ultraviolets par le film masque 2 forment des parties en relief 17.

On procède ainsi de la même façon pour réaliser les différents clichés 10 nécessaires, correspondant respectivement aux différentes couleurs que l'on souhaite appliquer sur le support. Les cuvettes 18 des différents clichés réalisés, provenant toutes des mêmes zones respectives 7 non masquées d'un même masque sont donc rigoureusement positionnées de la même façon par rapport au sujet à reproduire 3.

Comme représenté sur les figures 5 à 8, on utilise ensuite un dispositif de positionnement 20, constitué d'un plateau de base 21 sur lequel sont disposés d'une part deux montants verticaux 22 supportant une platine horizontale 24 et, d'autre part, deux supports 26 comportant chacun une échancrure 27 en forme de V ,ouverte à sa partie supérieure. Les plans des deux supports 26 sont orientés de façon telle que les segments constituant les bases des échancrures en V 27 soient alignées suivant un axe zz′ parallèle à la platine 24. Les cylindres d'impression 19 sont prolongés, à chacune de leurs extrémités, par des axes longitudinaux 28, qui viennent se loger dans les échancrures en V 27 des supports 26, si bien que les axes zz′ des différents cylindres d'impression 19 se trouvent automatiquement positionnés suivant une même direction fixe par rapport à la platine 24.

Cette dernière comporte des brides de fixation 30, (deux dans le mode de mise en oeuvre représenté), constituées d'une entretoise 32, surmontée d'une partie 34 parallèle à la platine 24. La partie 34 est percée d'un trou fileté vertical recevant une vis de fixation 36, prolongée d'une broche de centrage 37 (figure 9) dont l'extrémité 38 est de forme complémentaire de celle de la cuvette 18, c'est-à-dire dans le cas présent de forme semi-sphérique, d'un diamètre égal à celui des cuvettes 18. De préférence l'axe yy′ joignant le centre des deux broches de centrage 37 est parallèle à l'axe zz′ des rouleaux d'impression 19.

Dans ces conditions, pour procéder au positionnement et à la fixation d'un cliché 10 sur un cylindre d'impression 19, on présente tout d'abord les cuvettes 18 formées, par exemple, à la partie supérieure du cliché 10, au droit des deux broches de centrage respectives 37, et on visse ces dernières pour que leurs extrémités semi-sphériques 38 viennent se loger dans les cuvettes 18, ce qui assure d'une part un positionnement et un centrage rigoureux de l'axe xx′ joignant le centre des cuvettes 18 du cliché 10, avec l'axe yy′ joignant les deux broches de centrage 36 37 et, d'autre part, un maintien du cliché 10 sur la platine 24.

Comme représenté sur la figure 7, on applique alors l'extrémité libre du cliché 10 sur le cylindre d'impression 19 et on la fixe sur celui-ci, de manière habituelle, par exemple à l'aide de moyens auto-adhésifs. On libère alors 15 les extrémités du cliché 10, maintenues par les broches de centrage 37, en dévissant les vis 36, et on termine, comme représenté sur la figure 8, l'enroulement et la fixation du cliché 10 sur le cylindre d'impression 19. Ce dernier est ainsi prêt à être utilisé sur la machine d'impression. On procède ainsi de la même façon pour positionner et fixer les autres clichés sur les autres cylindres d'impression.

Bien entendu, comme représenté sur la figure 10 la zone 5 du film masque 1, à l'intérieur de laquelle est prévue la zone non masquée 7, peut être de forme quelconque.

On pourrait également, pour réaliser le positionnement et le maintien du cliché, faire appel à des broches de centrage se déplaçant verticalement, à l'aide d'autres moyens que le vissage. On pourrait ainsi utiliser des broches de centrage actionnées par des dispositifs de commande de tout type connu, tels que des dispositifs de commande à genouillère.

On pourrait également, comme représenté sur la figure 11, utiliser des supports 40, montés coulissants longitudinalement sur un guide 31 sensiblement parallèle à l'axe zz′ des cylindres d'impression 19, et que l'on peut immobiliser à l'aide de vis 33. Une telle disposition permet de positionner latéralement les cuvettes 18 sur le cliché 10, en fonction, par exemple, des dimensions du sujet 3 à reproduire et/ou de la géométrie de celui-ci. De plus on remarque, comme montré sur la figure 12, qu'il n'est pas impératif que les cuvettes 18 soient alignées suivant un axe parallèle à l'axe zz′ des cylindres d'impression 19, et les axes yl y′l, y2 y′2,. ....yn y′n joignant les centres de deux cuvettes 18 successives peuvent former un angle quelconque avec l'axe zz′.

On pourrait également, au cours de l'opération de réalisation des clichés 10, et comme représenté sur la figure 13, poursuivre l'attaque chimique de façon que le cliché se trouve traversé de part en part. On obtiendrait ainsi un élément repère 18' constitué, d'un logement cylindrique dans lequel la broche de centrage pourrait pénétrer plus profondément de manière à assurer un positionnement plus précis du cliché 10.

## Revendications

**1.-** Procédé de positionnement d'une série de clichés, par exemple en photopolymère, sur des cylindres d'impression (19) dans lequel :
- on réalise sur un film masque transparent (1), conjointement au dessin d'un sujet (3) à reproduire, au moins deux zones masque (5), disposées à distance l'une de l'autre,
- on insole le cliché (10) au travers du film masque transparent (1),
- on élimine les parties non insolées du cliché (10) par attaque chimique de celui-ci, de façon à obtenir sur le cliché (10), à l'endroit de chaque zone masque (5), un élément repère (18), caractérisé en ce que, de façon successive pour chacun des clichés :
- on réalise des zones masques constituées de deux zones opaques (5), sensiblement au milieu desquelles est formée une zone non masquée (7), de façon à constituer sur le cliché (10), après contretypage du film masque initial (1), une partie en relief (17) au centre de laquelle se trouve une cuvette (18),
- on met, en contact avec chaque bord interne de chaque cuvette (18) un élément (38) de forme complémentaire de celle-ci, dont la position par rapport à l'axe longitudinal zz′ de chaque cylindre d'impression (19) est respectivement la même, de façon à assurer le positionnement et le maintien de la cuvette (18) par l'élément de forme complémentaire (38),
- on fixe, sur le cylindre d'impression (19), la partie de cliché (10) non maintenue par les éléments de forme complémentaire (38),
- on libère la partie de cliché (10) maintenue par ces derniers,
- on termine la fixation du cliché (10) sur le cylindre d'impression (19).

**2.-** Procédé suivant la revendication 1 caractérisé en ce que le fond de la cuvette (18) est de forme sensiblement semi-sphérique, et l'élément de forme complémentaire est constitué d'une broche (37) d'extrémité (38) semi-sphérique.

**3.-** Procédé suivant la revendication 2 caractérisé en ce que l'on fait subir au matériau photopolymère constituant un cliché (19), une fois celui-ci insolé, une attaque chimique telle que celle-ci creuse le matériau photopolymère sensiblement de part en part.

**4.-** Dispositif de positionnement de clichés (10) sur des cylindres d'impression (19) respectifs, caractérisé en ce qu'il comprend :
- des moyens de positionnement, aptes à disposer et à maintenir les différents cylindres d'impression (19), de façon que leur axe longitudinal zz′ soit disposé suivant une direction fixe déterminée,
- des moyens de maintien, constitués d'au moins deux éléments de forme complémentaire (38) d'éléments repère (18), réalisés en creux sur chacun des différents clichés (10), aptes à coopérer avec ces derniers pour positionner et maintenir chacun des clichés (10) suivant une même direction déterminée par rapport à l'axe zz′ du cylindre d'impression (19).

**5.-** Dispositif suivant la revendication 4 caractérisé en ce que lesdits éléments repères sont en forme de cuvette semi-sphérique (18).

**6.-** Dispositif suivant l'une des revendications 4 ou 5 caractérisé en ce que les moyens de positionnement de l'axe zz′ du cylindre d'impression (19) sont constitués de deux supports identiques (26), dont la partie supérieure est pourvue d'une échancrure (27) en forme de V, ces deux supports (26) étant disposés de telle façon que les intersections des parois des échancrures inférieures respectives soient alignées suivant l'axe zz′ suivant lequel on souhaite positionner l'axe du cylindre d'impression (19), et d'une platine support (24) parallèle à l'axe zz′, lorsque celui-ci est en place sur les supports (26), et qui supporte les moyens de maintien des éléments de forme complémentaire (38) de l'élément repère (18).

**7.-** Dispositif suivant la revendication 6 caractérisé en ce que les éléments de forme complémentaire (38) de l'élément repère (18) sont constitués de broches (37,37′) mobiles verticalement, dont l'extrémité (38) est de forme complémentaire de celle de l'élément repère (18), ces broches (37,37′) comportant des moyens (36) destinés à assurer leur immobilisation.

**8.-** Dispositif suivant la revendication 7 caractérisé en ce que les broches (37) de positionnement et de maintien du cliché (19) sont solidaires d'une vis (36) d'axe sensiblement vertical, vissée dans un support (30) solidaire de la platine (24).

**9.-** Dispositif suivant la revendication 6 caractérisé en ce que les moyens de maintien desdits éléments de forme complémentaire (38) sont montés sur un support (40), mobile en translation sur une glissière (41) parallèle à l'axe zz′ du cylindre d'impression (19), lorsque celui-ci est en place sur son support (26).

**10.-** Dispositif suivant la revendication 7 caractérisé en ce que le matériau photopolymère est traversé sensiblement de part en part par une cavité (18′).
